(19) Europäisches Patentamt
European Patent Office
Office européen des brevets

(11) **EP 3 588 105 B1**

(12) **FASCICULE DE BREVET EUROPEEN**

(45) Date de publication et mention
de la délivrance du brevet:
**29.07.2026 Bulletin 2026/31**

(21) Numéro de dépôt: **19180718.9**

(22) Date de dépôt: **17.06.2019**

(51) Classification Internationale des Brevets (IPC):
***G01R 22/06*** *(2006.01)* ***G01R 31/327*** *(2006.01)*

(52) Classification Coopérative des Brevets (CPC):
**G01R 22/068; G01R 31/3278**

(54) **COMPTEUR ELECTRIQUE COMPORTANT UN ORGANE DE COUPURE AUXILIAIRE AGENCE POUR RACCORDER SELECTIVEMENT UN EQUIPEMENT D'UNE INSTALLATION AU RESEAU ELECTRIQUE**

STROMZÄHLER, DER EIN HILFSSCHALTORGAN ZUM SELEKTIVEN ANSCHLIESSEN VON GERÄTEN EINER ANLAGE AN EIN STROMNETZ UMFASST

ELECTRICITY METER COMPRISING AN AUXILIARY INTERRUPTING MEMBER ARRANGED FOR SELECTIVELY CONNECTING EQUIPMENT OF AN INSTALLATION TO THE POWER GRID

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **29.06.2018 FR 1856052**

(43) Date de publication de la demande:
**01.01.2020 Bulletin 2020/01**

(73) Titulaire: **Sagemcom Energy & Telecom SAS
92270 Bois-Colombes (FR)**

(72) Inventeurs:
• **JEANROT, Marc
92270 Bois-Colombes (FR)**
• **GRINCOURT, Christophe
92270 Bois-Colombes (FR)**
• **BRETON, Thierry
92270 Bois-Colombes (FR)**

(74) Mandataire: **Cabinet Boettcher
5, rue de Vienne
75008 Paris (FR)**

(56) Documents cités:
EP-A1- 2 940 484        EP-A2- 0 813 216
WO-A1-2008/064694        WO-A1-2013/189527
DE-A1- 4 011 049        FR-A1- 2 603 419
US-A1- 2008 074 215

**Description**

L'invention concerne le domaine des compteurs électriques qui comportent un organe de coupure auxiliaire agencé pour raccorder sélectivement un équipement d'une installation au réseau électrique.

ARRIERE PLAN DE L'INVENTION

Certains compteurs électriques, destinés à mesurer une énergie électrique fournie à une installation par un réseau électrique, sont équipés d'un organe de coupure auxiliaire permettant de raccorder sélectivement un équipement de l'installation au réseau électrique.

On parle classiquement, pour désigner cet organe de coupure auxiliaire, de contact sec ou de boucle sèche.

L'organe de coupure auxiliaire comprend classiquement un relais électromécanique muni d'une bobine de commande et d'un contact conducteur mobile actionné via un courant de commande circulant dans la bobine de commande.

Le relais électromécanique permet de commuter un courant de quelques ampères sous la tension secteur disponible sur le réseau électrique. Le relais électromécanique garantit de plus l'isolement galvanique entre le compteur électrique et l'équipement.

L'organe de coupure auxiliaire est activé de manière périodique (2 fois par jour en général).

L'organe de coupure auxiliaire permet notamment de gérer la consommation d'un ou de plusieurs équipements électriques de forte puissance. Lorsque l'énergie électrique est facturée à un coût réduit (on parle d'« heures creuses »), l'organe de coupure auxiliaire est fermé et autorise l'alimentation. Lorsque l'énergie électrique est facturée au tarif normal, (on parle d'« heures pleines »), l'organe de coupure auxiliaire est ouvert et n'autorise pas l'alimentation.

Grâce à l'utilisation de ce type d'organe de coupure auxiliaire, la consommation globale d'énergie électrique sur le réseau électrique est étalée dans le temps.

En cas de dysfonctionnement du relais électromécanique, et notamment en cas de collage du contact conducteur mobile du relais électromécanique en position ouverte ou fermée, l'équipement électrique sera soit alimenté en permanence, ce qui induit un surcoût pour l'abonné utilisateur de l'installation, soit jamais alimenté, ce qui empêche la mise en œuvre de la fonction dans laquelle est utilisé l'équipement électrique.

Il est donc nécessaire d'assurer que l'organe de coupure auxiliaire, suite à une commande d'ouverture ou de fermeture, a bien commuté. À titre d'exemple de l'état de la technique, le document EP2 940 484 A1 décrit un compteur électrique muni d'un organe de coupure auxiliaire.

Une méthode classiquement mise en œuvre pour vérifier que l'organe de coupure auxiliaire a bien commuté consiste à détecter, du côté de l'équipement électrique de l'installation, l'état réel, ouvert ou fermé, de l'organe de coupure auxiliaire.

L'inconvénient principal de cette méthode est qu'elle nécessite de transmettre l'information sur l'état réel de l'organe de coupure auxiliaire au travers de l'isolation galvanique du relais électromécanique.

Cette méthode entraîne ainsi un surcoût lié aux composants d'isolation et de mesure qui doivent être compatibles avec les spécifications liées à la tension secteur. De plus, ces composants sont en général assez volumineux et entraînent une augmentation de la taille du circuit imprimé.

On connaît aussi un système de détermination de défaillance de relais électromécanique, qui utilise un accéléromètre pour détecter la vibration induite par le mouvement du contact conducteur mobile lors de son basculement. Ce système est à la fois coûteux et encombrant.

OBJET DE L'INVENTION

L'invention est mise en œuvre sur un compteur électrique muni d'un organe de coupure auxiliaire comprenant un relais électromécanique, et a pour but de détecter un fonctionnement défectueux du relais électromécanique de manière fiable, peu coûteuse, et sans augmenter le volume et la masse du compteur électrique.

RESUME DE L'INVENTION

En vue de la réalisation de ce but, on propose un compteur électrique destiné à mesurer une énergie électrique fournie à une installation par un réseau électrique, le compteur électrique comportant un organe de coupure agencé pour raccorder sélectivement un équipement de l'installation au réseau électrique, l'organe de coupure comprenant un relais électromécanique muni d'au moins une bobine de commande, le compteur électrique comportant de plus un circuit de commande agencé pour générer une commande d'ouverture ou de fermeture du relais électromécanique, la commande d'ouverture ou de fermerure produisant un courant de commande circulant dans la bobine de commande, le compteur électrique comportant en outre un circuit de mesure agencé pour produire des mesures du courant de commande, et pour détecter un état réel ouvert ou fermé du relais électromécanique à partir des mesures du courant de commande.

Le compteur électrique selon l'invention détecte donc un état réel du relais électromécanique grâce à un circuit de mesure très simple et comprenant un nombre réduit de composants qui sont peu encombrants et peu coûteux. Comme le circuit de mesure est agencé pour mesurer le courant de commande et pour détecter l'état réel du relais électromécanique grâce à ces mesures, le circuit de mesure est positionné du côté du circuit de commande, en amont du relais électromécanique, de sorte qu'il n'est pas nécessaire de transmettre des informations au travers de l'isolation galvanique.

On propose de plus un compteur électrique tel que celui qui vient d'être décrit, dans lequel l'état réel du relais électromécanique est détecté en fonction d'une survenue ou d'une absence de survenue, au cours d'une première durée prédéterminée faisant suite à un déclenchement de la commande d'ouverture ou de fermeture, d'au moins un profil prédéterminé de variation du courant de commande.

On propose aussi un compteur électrique dans lequel le circuit de mesure est en outre agencé pour détecter un défaut de la bobine de commande ou du circuit de commande lorsque, suite à un déclenchement de la commande d'ouverture ou de fermeture, le courant de commande demeure, pendant une deuxième durée prédéterminée, inférieur à un seuil de courant prédéterminé.

On propose aussi un procédé de commande d'un relais électromécanique d'un compteur électrique tel que celui qui vient d'être décrit, comportant les étapes de :

- produire une commande d'ouverture ou de fermeture du relais électromécanique ;
- mesurer le courant de commande ;
- si le courant de commande demeure, pendant la deuxième durée prédéterminée, inférieur au seuil de courant prédéterminé, détecter un défaut de la bobine de commande ou du circuit de commande ;
- si le courant de commande devient, au cours de la deuxième durée prédéterminée, supérieur ou égal au seuil de courant prédéterminé, détecter un état réel ouvert ou fermé du relais électromécanique à partir des mesures du courant de commande ;
- si l'état réel du relais électromécanique ne correspond pas à la commande d'ouverture ou de fermeture, produire une commande inversée correspondant à l'état réel du relais électromécanique.

On propose de plus un programme d'ordinateur comprenant des instructions pour mettre en œuvre, par un microcontrôleur d'un compteur électrique, le procédé de commande qui vient d'être décrit.

On propose en outre des moyens de stockage, caractérisés en ce qu'ils stockent un programme d'ordinateur comprenant des instructions pour mettre en œuvre, par un microcontrôleur d'un compteur électrique, le procédé de commande qui vient d'être décrit.

L'invention sera mieux comprise à la lumière de la description qui suit d'un mode de mise en œuvre particulier non limitatif de l'invention.

BREVE DESCRIPTION DES DESSINS

Il sera fait référence aux dessins annexés, parmi lesquels :

- la figure 1 est un schéma électrique d'un relais électromécanique, d'un circuit de commande et d'un circuit de mesure d'un compteur électrique selon l'invention ;
- la figure 2 est un graphique sur lequel est représentée une courbe d'une tension de mesure représentative d'un courant de commande de fermeture, le relais électromécanique étant fonctionnel ;
- la figure 3 est un graphique similaire à celui de la figure 2, alors qu'un contact conducteur mobile du relais électromécanique est bloqué ;
- la figure 4 est un graphique sur lequel est représenté une courbe d'une tension de mesure représentative d'un courant de commande d'ouverture, le relais électromécanique étant fonctionnel ;
- la figure 5 est un graphique similaire à celui de la figure 4, alors que le contact conducteur mobile est bloqué ;
- la figure 6 représente des étapes d'un procédé de commande mis en œuvre dans le compteur électrique selon l'invention.

DESCRIPTION DETAILLEE DE L'INVENTION

Un compteur électrique selon l'invention est destiné à mesurer une énergie électrique fournie à une installation par un réseau électrique.

Le compteur électrique comporte un organe de coupure auxiliaire destiné à raccorder sélectivement, en fonction d'une commande d'ouverture ou d'une commande de fermeture de l'organe de coupure auxiliaire, un équipement de l'installation au réseau électrique. L'équipement en question est donc relié au réseau électrique via l'organe de coupure auxiliaire du compteur électrique.

L'organe de coupure comprend un relais électromécanique muni d'au moins une bobine de commande.

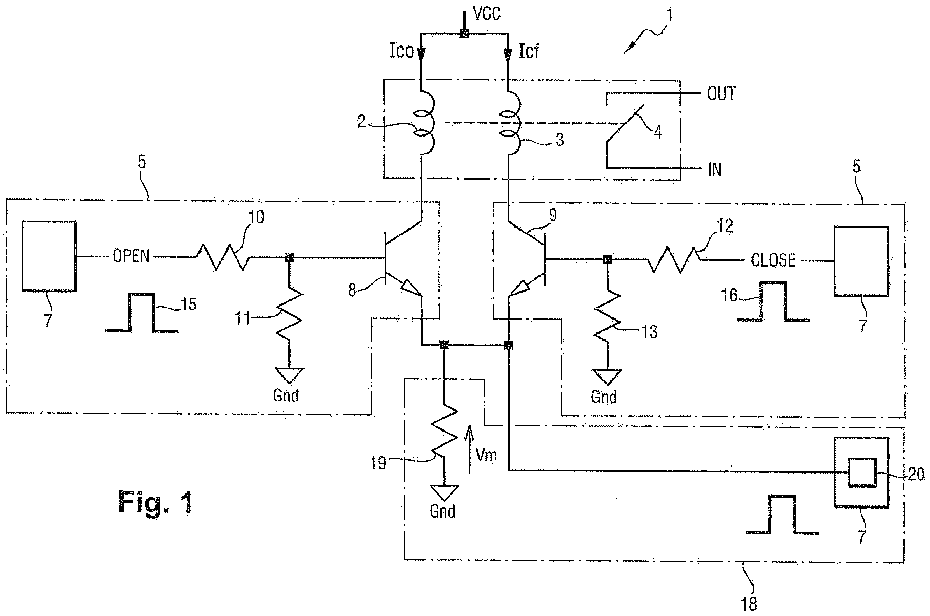

En référence à la figure 1, le relais électromécanique 1 est ici un relais bistable comprenant une bobine de commande d'ouverture 2, une bobine de commande de fermeture 3 et un contact conducteur mobile 4.

La bobine de commande d'ouverture 2 a ici une résistance interne Rbo telle que :

$$Rbo = 330\Omega.$$

La bobine de commande de fermeture 3 a ici une résistance interne Rbf telle que :

$$Rbf = 330\Omega.$$

Le compteur électrique comporte de plus un circuit de commande 5. Le circuit de commande 5 est alimenté par une tension d'alimentation continue Vcc et comprend un composant de traitement 7, un premier transistor 8, un deuxième transistor 9, une première résistance 10, une deuxième résistance 11, une troisième résistance 12 et une quatrième résistance 13.

La tension d'alimentation continue Vcc est ici une tension continue de 14V.

Le composant de traitement 7 est ici un microcontrôleur 7 mais pourrait être un composant différent, par exemple un FPGA. Le composant de traitement 7 est adapté à exécuter des instructions d'un programme pour mettre en œuvre le procédé de commande qui sera décrit plus bas.

Le premier transistor 8 et le deuxième transistor 9 sont ici tous deux des transistors bipolaires NPN.

La tension d'alimentation continue Vcc est appliquée sur une première borne de la bobine de commande d'ouverture 2 et sur une première borne de la bobine de commande de fermeture 3.

Un émetteur du premier transistor 8 est connecté à une deuxième borne de la bobine de commande d'ouverture 2. Un émetteur du deuxième transistor 9 est connecté à une deuxième borne de la bobine de commande de fermeture 3.

La première résistance 10 comprend une première borne reliée à une première borne de la deuxième résistance 11. La deuxième résistance 11 comprend une deuxième borne reliée à une masse électrique Gnd du compteur électrique. La première borne de la première résistance 10 et la première borne de la deuxième résistance 11 sont connectées à une base du premier transistor 8.

La troisième résistance 12 comprend une première borne reliée à une première borne de la quatrième résistance 13. La quatrième résistance 13 comprend une deuxième borne reliée à la masse électrique Gnd. La première borne de la troisième résistance 12 et la première borne de la quatrième résistance 13 sont connectées à une base du deuxième transistor 9.

La première résistance 10, la deuxième résistance 11, la troisième résistance 12 et la quatrième résistance 13 présentent ici chacune une valeur de résistance égale à 10kΩ.

Lorsqu'il convient d'ouvrir l'organe de coupure et donc le relais électromécanique 1, le circuit de commande 5 génère une commande d'ouverture. La commande d'ouverture est un échelon de tension d'ouverture 15 appliqué sur la deuxième borne de la première résistance 10 et donc sur la base du premier transistor 8. La durée de l'échelon de tension d'ouverture 15 est ici égale à 50ms. Le premier transistor 8 passe alors dans un état saturé. La commande d'ouverture produit ainsi un courant de commande d'ouverture Ico qui circule dans la bobine de commande d'ouverture 2. Le champ magnétique résultant déplace alors le contact conducteur mobile 4 et ouvre le relais électromécanique 1.

Le courant de commande d'ouverture est tel que :

$$Ico = Vcc/Rbo = 14/330 = 42mA.$$

Lorsqu'il convient de fermer l'organe de coupure et donc le relais électromécanique 1, le circuit de commande 5 génère une commande de fermeture. La commande de fermeture est un échelon de tension de fermeture 16 appliqué sur la deuxième borne de la troisième résistance 12 et donc sur la base du deuxième transistor 9. La durée de l'échelon de tension de fermeture 16 est ici égale à 50ms. Le deuxième transistor 9 passe alors dans un état saturé. La commande de fermeture produit ainsi un courant de commande de fermeture Icf qui circule dans la bobine de commande de fermeture 3. Le champ magnétique déplace alors le contact conducteur mobile 4 et ferme le relais électromécanique 1.

Le courant de commande de fermeture Icf est tel que

$$Icf = Vcc/Rbf = 14/330 = 42mA.$$

Le compteur électrique comporte de plus un circuit de mesure 18. Le circuit de mesure 18 comprend une résistance de mesure 19 et un convertisseur analogique numérique 20.

La résistance de mesure 19 comprend une première borne qui est reliée à un drain du premier transistor 8 et à un drain du deuxième transistor 9, et une deuxième borne qui est reliée à la masse électrique Gnd.

La résistance de mesure 19 présente une faible valeur de résistance, ici égale à $4,7\Omega$.

Le convertisseur analogique numérique 20 est ici intégré dans le microcontrôleur 7.

Le convertisseur numérique analogique 20 acquiert et numérise une tension de mesure Vm aux bornes de la résistance de mesure 19. La tension de mesure Vm est représentative, en l'occurrence proportionnelle au courant de commande d'ouverture Ico ou au courant de commande de fermeture Icf qui circulent respectivement dans la bobine de commande d'ouverture 2 (en cas de commande d'ouverture du relais électromécanique 1) ou dans la bobine de commande de fermeture 3 (en cas de commande de fermeture du relais électromécanique 1).

Le circuit de mesure 18 produit ainsi des mesures du courant de commande d'ouverture Ico et du courant de commande de fermeture Icf.

Le circuit de mesure 18 est agencé pour détecter un état réel ouvert ou fermé du relais électromécanique 1 à partir des mesures du courant de commande d'ouverture Ico et du courant de commande de fermeture Icf.

L'état réel du relais électromécanique 1 est détecté en fonction d'une survenue ou d'une absence de survenue, au cours d'une première durée prédéterminée faisant suite à un déclenchement de la commande d'ouverture ou de fermeture, d'au moins un profil prédéterminé de variation du courant de commande.

Les acquisitions du convertisseur analogique numérique 20 sont déclenchées par un signal d'acquisition synchronisé sur chaque échelon de tension d'ouverture 15 et chaque échelon de tension de fermeture 16. Pour chaque commande d'ouverture, respectivement de fermeture, les acquisitions débutent donc au déclenchement d'un échelon de tension d'ouverture 15, respectivement d'un échelon de tension de fermeture 16, et sont réalisées pendant une durée inférieure ou égale à la durée de 50ms de chaque échelon.

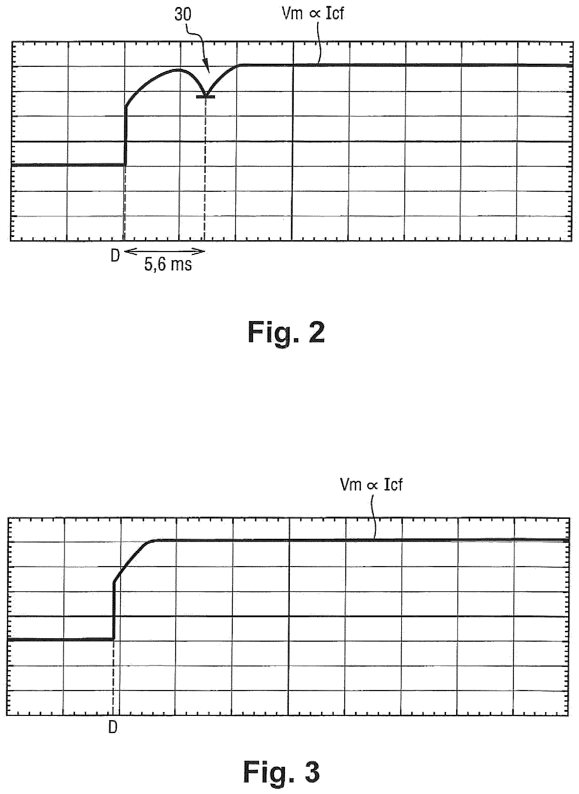

En référence à la figure 2, on voit que, lorsqu'une commande de fermeture est générée par le circuit de commande 5 et que la fermeture du relais électromécanique 1 est effective, on distingue, 5.6ms après le déclenchement D de la commande de fermeture, une chute de tension 30 de 64mV sur la tension de mesure Vm, qui correspond à une chute du courant de commande de fermeture Icf se produisant au moment de la commutation physique du relais électromécanique 1.

En référence à la figure 3, on voit que, lorsqu'une commande de fermeture est générée par le circuit de commande 5 et que le contact conducteur mobile 4 est bloqué, empêchant ainsi le relais électromécanique 1 de se fermer, on n'observe pas cette chute de tension sur la tension de mesure Vm et donc on détecte une absence de survenue de la chute du courant de commande de fermeture Icf.

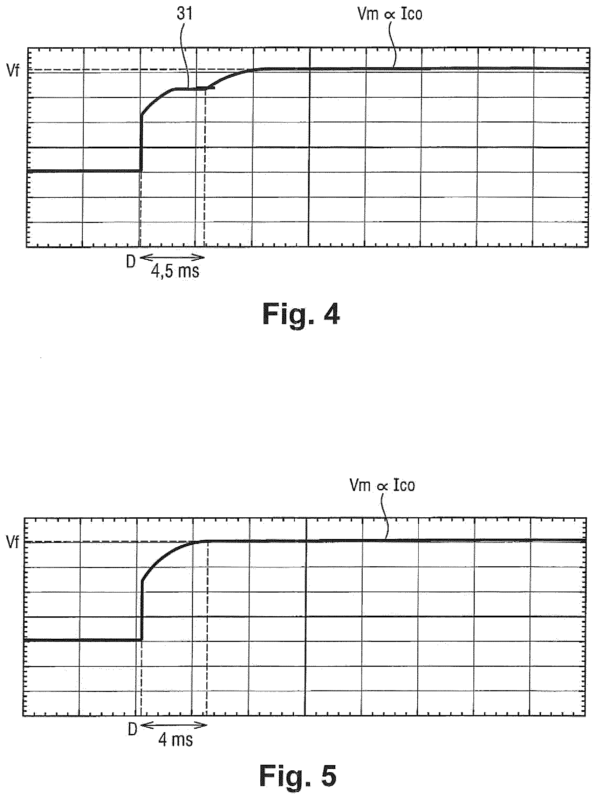

De même, en référence à la figure 4, on voit que, lorsqu'une commande d'ouverture est générée par le circuit de commande 5 et que l'ouverture du relais électromécanique 1 est effective, on distingue un palier 31 atteint par la tension de mesure Vm, et donc par le courant de commande d'ouverture Ico, avant que la tension de mesure Vm (et donc le courant de commande d'ouverture) n'atteigne sa valeur finale Vf. La tension de mesure Vm plafonne à un seuil inférieur de 40mV à sa valeur finale Vf. Le palier dure jusqu'à 4.5ms après le déclenchement D de la commande d'ouverture.

En référence à la figure 5, on voit que, lorsqu'une commande d'ouverture est générée par le circuit de commande 5 et que le contact conducteur mobile 4 est bloqué, empêchant ainsi le relais électromécanique 1 de s'ouvrir, on n'observe pas ce palier sur la tension de mesure Vm. La tension maximale finale Vf est atteinte 4ms après le déclenchement de la commande de fermeture.

Ainsi, lorsque le circuit de commande 5 génère une commande de fermeture, l'état réel du relais électromécanique 1 est détecté en fonction d'une survenue ou d'une absence de survenue, au cours d'une première durée prédéterminée faisant suite à un déclenchement de la commande de fermeture, d'au moins un profil prédéterminé de variation du courant de commande de fermeture Icf.

La première durée prédéterminée est supérieure à 5.6ms, et est par exemple ici égale à 15ms.

Ici, le profil prédéterminé de variation du courant de commande de fermeture comprend une chute du courant de commande de fermeture. L'état réel fermé est détecté en cas de survenue d'une chute du courant de commande de fermeture au cours de la première durée prédéterminée. L'état réel ouvert est détecté en cas d'absence de survenue d'une chute du courant de commande de fermeture au cours de la première durée prédéterminée

De même, lorsque le circuit de commande 5 génère une commande d'ouverture, l'état réel du relais électromécanique 1 est détecté en fonction d'une survenue ou d'une absence de survenue, au cours de la première durée prédéterminée faisant suite à un déclenchement de la commande d'ouverture, d'au moins un profil prédéterminé de variation du courant de commande d'ouverture Ico.

Ici, le profil prédérerminé de variation du courant de commande d'ouverture comprend un palier atteint par le courant de commande d'ouverture. L'état réel ouvert est détecté en cas de survenue du palier au cours de la première durée prédéterminée. L'état réel fermé est détecté en cas d'absence de survenue du palier au cours de la première durée prédéterminée.

Bien sûr, on a évoqué ici une seule et même première durée prédéterminée utilisée pour déterminer la survenue ou l'absence de survenue du profil prédéterminé de variation du courant de commande, mais il serait possible d'utiliser deux premières durées prédéterminées différentes, l'une pour une commande de fermeture et l'autre pour une commande d'ouverture.

Le circuit de mesure 18 est aussi agencé pour détecter un défaut de la bobine de commande d'ouverture 2 ou du circuit de commande 5 lorsque, suite à un déclenchement de la commande d'ouverture, le courant de commande d'ouverture Ico demeure, pendant une deuxième durée prédéterminée, inférieur à un seuil de courant prédéterminé.

De même, le circuit de mesure 18 est agencé pour détecter un défaut de la bobine de commande de fermeture 3 ou du circuit de commande 5 lorsque, suite à un déclenchement de la commande de fermeture, le courant de commande de fermeture Icf demeure, pendant la deuxième durée prédéterminée, inférieur au seuil de courant prédéterminé.

Bien sûr, à nouveau, on pourrait avoir non pas une seule deuxième durée prédéterminée mais deux deuxièmes durées prédéterminées, l'une pour l'ouverture et l'autre pour la fermeture.

Le convertisseur analogique numérique 20 doit pouvoir distinguer une chute de tension de 50mV. En choisissant une dynamique de 50 LSB (pour *Least Significant Bit*), on obtient un LSB de 1mV.

On choisit ici un convertisseur analogique numérique 20 de 12 bits alimenté en 3,3V.

Le LSB est donc égal à :

$$3,3 \ / \ 2.e^{12} \ \approx \ 805\mu V.$$

Le convertisseur analogique numérique 20 choisi est donc suffisamment performant.

Le convertisseur analogique numérique 20 réalise ici dix mesures sur une durée de 10ms, de sorte que sa fréquence d'échantillonnage est égale à 1kHz. Cette fréquence d'échantillonnage est suffisante pour bien définir la forme du courant de commande (d'ouverture ou de fermeture) et donc pour détecter la survenue ou l'absence de survenue des profils prédéterminés de variation.

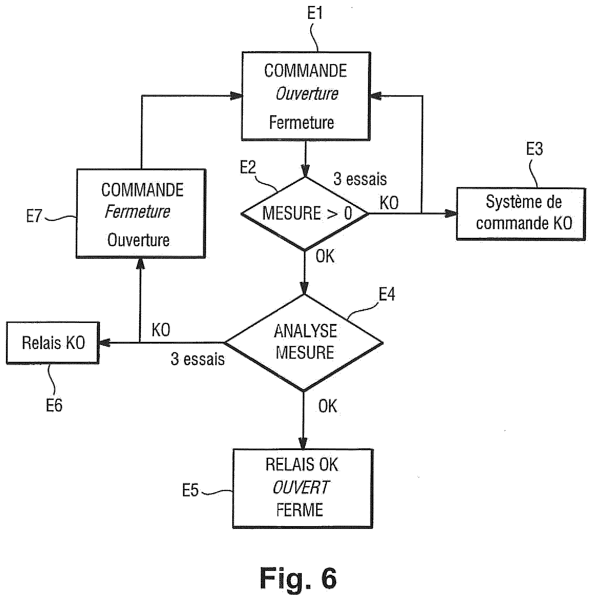

On décrit maintenant, en référence à la figure 6, un procédé de commande du relais électromécanique 1 du compteur électrique.

Le procédé de commande comprend tout d'abord l'étape de produire une commande d'ouverture ou de fermeture du relais électromécanique 1 : étape E1. La commande d'ouverture ou de fermeture est produite par le microcontrôleur 7.

Le circuit de mesure 18 mesure alors le courant de commande (d'ouverture ou de fermeture) : étape E2. Si le courant de commande demeure, pendant la deuxième durée prédéterminée, inférieur au seuil de courant prédéterminé, une suspicion de premier défaut est détectée.

Lorsque trois suspicions de premier défaut consécutives ont été détectées, le circuit de mesure 18 détecte un défaut de la bobine de commande d'ouverture 2 ou du circuit de commande 5 (si la commande est une commande d'ouverture), ou bien un défaut de la bobine de commande de fermeture 3 ou du circuit de commande 5 (si la commande est une commande de fermeture) : étape E3.

Au moment de l'étape E2, si le courant de commande devient, au cours de la deuxième durée prédéterminée, supérieur ou égal au seuil de courant prédéterminé, on ne détecte pas de défaut de la bobine de commande d'ouverture ou de fermeture, ni du circuit de commande.

L'état réel ouvert ou fermé du relais électromécanique 1 est alors détecté à partir des mesures du courant de commande (d'ouverture ou de fermeture), c'est à dire en fonction de la survenue ou de l'absence de survenue des profils prédéterminés de variation qui ont été décrits : étape E4.

Si la commande était une commande d'ouverture et qu'un état ouvert du relais électromécanique 1 est détecté, aucun défaut n'est détecté. De même, si la commande était une commande de fermeture et qu'un état fermé du relais électromécanique 1 est détecté, aucun défaut n'est détecté : étape E5.

Par contre, si la commande était une commande d'ouverture et qu'un état fermé du relais électromécanique 1 est détecté, ou bien si la commande était une commande de fermeture et qu'un état ouvert du relais électromécanique 1 est détecté, c'est à dire si l'état réel du relais électromécanique 1 ne correspond pas à la commande, une suspicion de deuxième défaut est détectée.

Lorsque trois suspicions de deuxième défaut consécutives ont été détectées, on détecte un défaut du relais électromécanique 1 : étape E6.

Si un défaut du relais électromécanique 1 est détecté et que la commande était une commande d'ouverture, une commande inversée, c'est à dire une commande de fermeture, est alors produite. De même, si un défaut du relais électromécanique 1 est détecté et que la commande était une commande de fermeture, une commande inversée, c'est à dire une commande d'ouverture, est alors produite : étape E7.

En effet, dans chacun de ces deux cas, le relais électromécanique 1 était déjà, avant même la commande d'ouverture ou de fermeture, dans l'état correspondant à l'état de la commande inversée. La dernière commande correspond ainsi à l'état réel du relais électromécanique 1 en défaut, ce qui permet d'assurer qu'une information erronée du l'état réel du relais électromécanique ne soit prise en compte.

Bien entendu, l'invention n'est pas limitée au mode de réalisation décrit mais englobe toute variante entrant dans le champ de l'invention telle que définie par les revendications.

Le relais électromécanique pourrait comprendre une seule bobine de commande, ou un nombre de bobines de commande différent de deux.

Les composants électriques utilisés dans le compteur électrique pourraient bien sûr être différents de ceux présentés ici. Par exemple, les transistors pourraient être différents, les caractéristiques des composants choisis pourraient être différentes, le convertisseur analogique numérique pourrait être un composant externe au microcontrôleur, etc.

**Revendications**

1. Compteur électrique destiné à mesurer une énergie électrique fournie à une installation par un réseau électrique, le compteur électrique comportant un organe de coupure agencé pour raccorder sélectivement un équipement de l'installation au réseau électrique, l'organe de coupure comprenant un relais électromécanique (1) muni d'au moins une bobine de commande (2, 3), le compteur électrique comportant de plus un circuit de commande (5) agencé pour générer une commande d'ouverture ou de fermeture du relais électromécanique, la commande d'ouverture ou de fermeture produisant un courant de commande (Ico, Icf) circulant dans la bobine de commande, le compteur électrique comportant en outre un circuit de mesure (18) agencé pour produire des mesures du courant de commande, et pour détecter un état réel ouvert ou fermé du relais électromécanique à partir des mesures du courant de commande,
l'état réel du relais électromécanique étant détecté en fonction d'une survenue ou d'une absence de survenue, au cours d'une première durée prédéterminée faisant suite à un déclenchement (D) de la commande d'ouverture ou de fermeture, d'au moins un profil prédéterminé de variation (30, 31) du courant de commande, le compteur électrique étant **caractérisé en ce que** l'un des au moins un profil prédéterminé de variation comprend un palier atteint par le courant de commande.

2. Compteur électrique selon la revendication 1, l'un des au moins un profil prédéterminé de variation comprenant une chute du courant de commande.

3. Compteur électrique selon l'une des revendications précédentes, dans lequel le circuit de commande comprend un transistor (8, 9) connecté à la bobine de commande, et dans lequel le circuit de mesure comprend une résistance de mesure (19) qui est connectée à la bobine de commande et dans laquelle circule le courant le commande.

4. Compteur électrique selon l'une des revendications précédentes, dans lequel le circuit de mesure est en outre agencé pour détecter un défaut de la bobine de commande ou du circuit de commande lorsque, suite à un déclenchement de la commande d'ouverture ou de fermeture, le courant de commande demeure, pendant une deuxième durée prédéterminée, inférieur à un seuil de courant prédéterminé.

5. Compteur électrique selon l'une des revendications précédentes, dans lequel le relais électromécanique est un relais bistable comprenant une bobine de commande d'ouverture (2) et une bobine de commande de fermeture (3), le circuit de commande étant agencé pour générer une commande d'ouverture du relais électromécanique, la commande d'ouverture produisant un courant de commande d'ouverture (Ico) circulant dans la bobine de commande d'ouverture, et pour générer une commande de fermeture du relais électromécanique, la commande de fermeture produisant un courant de commande de fermeture (Icf) circulant dans la bobine de commande de fermeture.

6. Procédé de commande d'un relais électromécanique d'un compteur électrique selon la revendication 4, comportant les étapes de :

   - produire une commande d'ouverture ou de fermeture du relais électromécanique ;
   - mesurer le courant de commande ;
   - si le courant de commande demeure, pendant la deuxième durée prédéterminée, inférieur au seuil de courant prédéterminé, détecter un défaut de la bobine de commande ou du circuit de commande ;
   - si le courant de commande devient, au cours de la deuxième durée prédéterminée, supérieur ou égal au seuil de courant prédéterminé, détecter un état réel ouvert ou fermé du relais électromécanique à partir des mesures du courant de commande, l'état réel du relais électromécanique étant détecté en fonction d'une survenue ou d'une absence de survenue, au cours d'une première durée prédéterminée faisant suite au déclenchement (D) de la commande d'ouverture ou de fermeture, d'au moins un profil prédéterminé de variation (30, 31) du courant de commande, l'un des au moins un profil prédéterminé de variation comprenant un palier atteint par le courant de commande ;
- si l'état réel du relais électromécanique ne correspond pas à la commande d'ouverture ou de fermeture, produire une commande inversée correspondant à l'état réel du relais électromécanique.

7. Programme d'ordinateur comprenant des instructions pour mettre en œuvre, par un microcontrôleur d'un compteur électrique, le procédé de commande selon la revendication 6.

8. Moyens de stockage, **caractérisés en ce qu'**ils stockent un programme d'ordinateur comprenant des instructions pour mettre en œuvre, par un microcontrôleur d'un compteur électrique, le procédé de commande selon la revendication 6.

## Patentansprüche

1. Stromzähler zur Messung einer elektrischen Energie, die einer Anlage über ein Stromnetz bereitgestellt wird, wobei der Stromzähler ein Abschaltorgan enthält, das dafür ausgelegt ist, ein Gerät der Anlage selektiv an das Stromnetz anzuschließen, wobei das Abschaltorgan ein elektromechanisches Relais (1) mit zumindest einer Steuerspule (2, 3) umfasst, wobei der Stromzähler ferner einen Steuerkreis (5) enthält, der dafür ausgelegt ist, einen Öffnungs- oder Schließbefehl zum Öffnen oder Schließen des elektromechanischen Relais zu erzeugen, wobei der Öffnungs- oder Schließbefehl einen Steuerstrom (Ico, Icf) erzeugt, der in der Steuerspule fließt, wobei der Stromzähler ferner einen Messkreis (18) enthält, der dafür ausgelegt ist, Messungen des Steuerstroms zu erzeugen und anhand der Messungen des Steuerstroms einen offenen oder geschlossenen Ist-Zustand des elektromechanischen Relais zu erkennen,
wobei der Ist-Zustand des elektromechanischen Relais in Abhängigkeit von einem Auftreten oder Nicht-Auftreten zumindest eines vorbestimmten Änderungsprofils (30, 31) des Steuerstroms während einer ersten vorbestimmten Zeitdauer nach einer Auslösung (D) des Öffnungs- oder Schließbefehls erkannt wird, wobei der Stromzähler **dadurch gekennzeichnet ist, dass** eines der zumindest einen vorbestimmten Änderungsprofile eine von dem Steuerstrom erreichte Stufe umfasst.

2. Stromzähler nach Anspruch 1, wobei eines der zumindest einen vorbestimmten Änderungsprofile einen Abfall des Steuerstroms umfasst.

3. Stromzähler nach einem der vorhergehenden Ansprüche, wobei der Steuerkreis einen mit der Steuerspule verbundenen Transistor (8, 9) umfasst, und wobei der Messkreis einen mit der Steuerspule verbundenen Messwiderstand (19) umfasst, durch welchen der Steuerstrom fließt.

4. Stromzähler nach einem der vorhergehenden Ansprüche, wobei der Messkreis ferner dafür ausgelegt ist, einen Defekt an der Steuerspule oder an dem Steuerkreis zu erkennen, wenn nach einer Auslösung des Öffnungs- oder Schließbefehls der Steuerstrom während einer zweiten vorbestimmten Zeitdauer kleiner als ein vorbestimmter Stromschwellenwert bleibt.

5. Stromzähler nach einem der vorhergehenden Ansprüche, wobei es sich bei dem elektromechanischen Relais um ein bistabiles Relais mit einer Öffnungssteuerspule (2) und einer Schließsteuerspule (3) handelt, wobei der Steuerkreis dafür ausgelegt ist, einen Öffnungsbefehl zum Öffnen des elektromechanischen Relais zu erzeugen, wobei der Öffnungsbefehl einen Öffnungssteuerstrom (Ico) erzeugt, der in der Öffnungssteuerspule fließt, und dafür ausgelegt ist, einen Schließbefehl zum Schließen des elektromechanischen Relais zu erzeugen, wobei der Schließbefehl einen Schließsteuerstrom (Icf) erzeugt, der in der Schließsteuerspule fließt.

6. Verfahren zum Steuern eines elektromechanischen Relais eines Stromzählers nach Anspruch 4, umfassend die Schritte, dass:

- ein Öffnungs- oder Schließbefehl zum Öffnen oder Schließen des elektromechanischen Relais erzeugt wird;
- der Steuerstrom gemessen wird;
- wenn der Steuerstrom während der zweiten vorbestimmten Zeitdauer kleiner als der vorbestimmte Stromschwellenwert bleibt, ein Defekt an der Steuerspule oder an dem Steuerkreis erkannt wird;

- wenn der Steuerstrom während der zweiten vorbestimmten Zeitdauer größer oder gleich dem vorbestimmten Stromschwellenwert wird, anhand der Messungen des Steuerstroms ein geöffneter oder geschlossener Ist-Zustand des elektromechanischen Relais erkannt wird, wobei der Ist-Zustand des elektromechanischen Relais in Abhängigkeit von einem Auftreten oder Nicht-Auftreten zumindest eines vorbestimmten Änderungsprofils (30, 31) des Steuerstroms während einer ersten vorbestimmten Zeitdauer nach der Auslösung (D) des Öffnungs- oder Schließbefehls erkannt wird, wobei eines der zumindest einen vorbestimmten Änderungsprofile eine von dem Steuerstrom erreichte Stufe umfasst;
- wenn der Ist-Zustand des elektromechanischen Relais nicht dem Öffnungs- oder Schließbefehl entspricht, ein invertierter Befehl erzeugt wird, der dem Ist-Zustand des elektromechanischen Relais entspricht.

7. Computerprogramm, welches Befehle umfasst, die einen Mikrocontroller eines Stromzählers dazu veranlassen, das Steuerverfahren nach Anspruch 6 auszuführen.

8. Speichermedien, **dadurch gekennzeichnet, dass** darauf ein Computerprogramm gespeichert ist, welches Befehle umfasst, die einen Mikrocontroller eines Stromzählers dazu veranlassen, das Steuerverfahren nach Anspruch 6 auszuführen.

## Claims

1. An electricity meter for measuring electrical energy supplied to an plant by an electrical grid, the electricity meter including a cut-off member arranged to selectively connect equipment of the plant to the electrical grid, the cut-off member including an electromechanical relay (1) provided with at least one control coil (2, 3), the electricity meter further including a control circuit (5) arranged to generate a command to open or close the electromechanical relay, the opening or closing command producing a control current (Ico, Icf) flowing in the control coil, the electricity meter further including a measurement circuit (18) arranged to produce measurements of the control current, and to detect an actual open or closed state of the electromechanical relay from the measurements of the control current, the actual state of the electromechanical relay being detected according to an occurrence or an absence of occurrence, during a first predetermined duration following a triggering (D) of the opening or closing command, of at least one predetermined variation profile (30, 31) of the control current, the electricity meter being **characterised in that** one of the at least one predetermined variation profile comprises a step reached by the control current.

2. The electricity meter according to claim 1, wherein one of the at least one predetermined variation profile comprises a drop in the control current.

3. The electricity meter according to any one of the preceding claims, wherein the control circuit comprises a transistor (8, 9) connected to the control coil, and wherein the measurement circuit comprises a measurement resistor (19) that is connected to the control coil and through which the control current flows.

4. The electricity meter according to any one of the preceding claims, wherein the measurement circuit is further arranged to detect a fault in the control coil or control circuit when, following a triggering of the opening or closing command, the control current remains, for a second predetermined duration, lower than a predetermined current threshold.

5. The electricity meter according to any one of the preceding claims, wherein the electromechanical relay is a bistable relay comprising an opening control coil (2) and a closing control coil (3), the control circuit being arranged to generate an opening command for the electromechanical relay, the opening command producing an opening control current (Ico) flowing in the opening control coil, and to generate a closing command for the electromechanical relay, the closing command producing a closing control current (Icf) flowing in the closing control coil.

6. A method for controlling an electromechanical relay of an electricity meter according to claim 4, the method comprising the steps of:

    - producing a command to open or close the electromechanical relay;
    - measuring the control current;
    - if the control current remains, during the second predetermined duration, below the predetermined current threshold, detecting a fault in the control coil or the control circuit;
    - if the control current becomes, during the second predetermined duration, greater than or equal to the predetermined current threshold, detecting an actual open or closed state of the electromechanical relay from the measurements of the control current, the actual state of the electromechanical relay being detected according to an occurrence or absence of occurrence, during a first predetermined duration following the triggering (D) of the opening or closing command, of at least one predetermined variation profile (30, 31) of the control current, one of the at least one predetermined variation profile comprising a step reached by the control current;

- if the actual state of the electromechanical relay does not correspond to the opening or closing command, producing a reverse command corresponding to the actual state of the electromechanical relay.

7. A computer program comprising instructions for enabling a microcontroller of an electricity meter to perform the control method according to claim 6.

8. Storage means **characterised in that** they store a computer program comprising instructions for enabling a microcontroller of an electricity meter to perform the control method according to claim 6.

Fig. 1

EP 3 588 105 B1

30

$Vm \propto Icf$

D $\overleftrightarrow{\quad 5,6\ ms\quad}$

## Fig. 2

$Vm \propto Icf$

D

## Fig. 3

EP 3 588 105 B1

31                                      Vm ∝ Ico

Vf

D ⟵⟶
   4,5 ms

# Fig. 4

Vm ∝ Ico

Vf

D ⟵⟶
   4 ms

# Fig. 5

13

E1

COMMANDE
*Ouverture*
Fermeture

E3

E2
3 essais

COMMANDE
*Fermeture*
Ouverture

E7

MESURE > 0

KO

Système de
commande KO

OK

E4

ANALYSE
MESURE

KO

Relais KO

3 essais

E6

OK

RELAIS OK
*OUVERT*
FERME

E5

**Fig. 6**

**EP 3 588 105 B1**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2940484 A1